# FASCICULE DE BREVET EUROPEEN

(11) **EP 3 460 497 B1**
(45) Date de publication et mention de la délivrance du brevet: **14.08.2024**
(21) Numéro de dépôt: 18196898.3
(22) Date de dépôt: 26.09.2018
(51) Int. Cl.: G01R 31/34, G01R 31/42, F03D 17/00

(54) **DISPOSITIF ET PROCÉDÉ DE TEST DE MODULES DE PUISSANCE**
VORRICHTUNG UND VERFAHREN ZUM TEST VON LEISTUNGSMODULEN
APPARATUS AND METHOD FOR TESTING POWER MODULES

(30) Priorité: 26.09.2017 FR 1758894
(43) Date de publication de la demande: 27.03.2019
(73) Titulaire: GE Energy Power Conversion Technology Ltd, Rugby, Warwickshire CV21 1BD (GB)
(72) Inventeur: PERON, Régis, 90000 BELFORT (FR)
(74) Mandataire: Casalonga

(56) Documents cités:
- WO-A1-2015/058769
- WO-A1-2017/106902
- US-A1- 2017 022 977

## Description

L'invention concerne un dispositif et un procédé de test d'un ensemble de modules de puissance électrique, et plus particulièrement d'un réseau de machines électriques synchrones multiphases et multicanaux et de leur convertisseur de puissance multicanaux associé.

L'invention est définie par le dispositif de la revendication 1 et le procédé de la revendication 7.

Par exemple, dans une application nullement limitative, les modules de puissance sont destinés à être intégrés dans des nacelles d'éoliennes. Les éoliennes incorporant le module de puissance sont raccordées entre elles et à un réseau électrique consommateur de puissance, de sorte à créer un champ de production d'énergie électrique en mer (« offshore », en anglais).

Il est nécessaire, avant la mise en production des modules de puissance, de vérifier les caractéristiques électriques et mécaniques de chaque module ainsi que les connexions reliant les modules entre eux et les reliant à un réseau électrique.

La procédure de test cherche à vérifier le fonctionnement de chaque module de puissance, c'est-à-dire le fonctionnement des chaînes de commande et d'acquisition comprenant des capteurs, des modules d'interfaçage, des actionneurs, la chaîne de puissance, et également les connexions entre les modules de puissance, et les connexions entre les modules de puissance et un réseau électrique auquel ils sont raccordés par l'intermédiaire d'un maillage des modules de puissance.

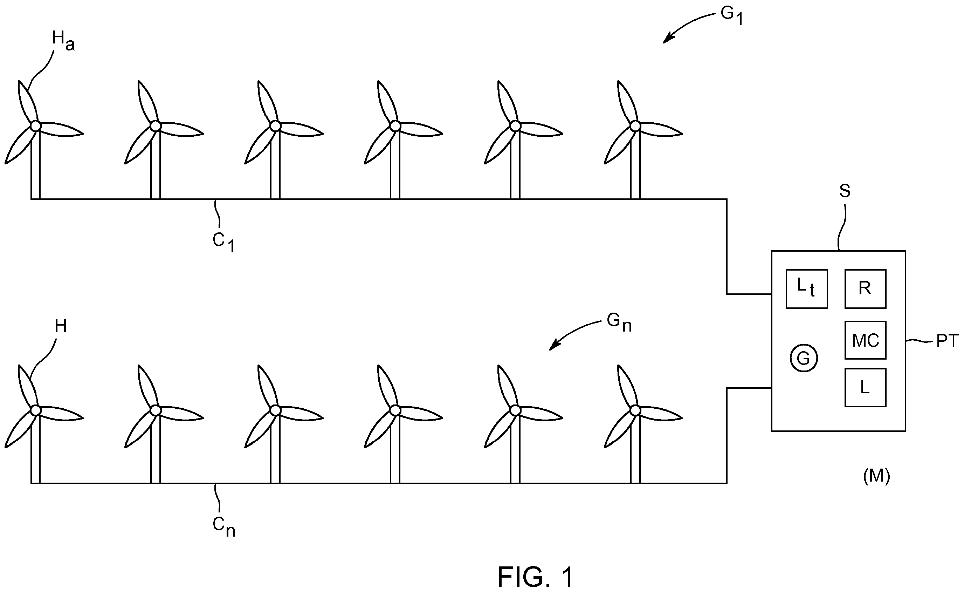

La figure 1 illustre un champ d'éoliennes offshore situé en mer (M) dans laquelle une procédure de test selon l'état de la technique peut être mise en oeuvre. Les éoliennes H sont reliées généralement par groupes G1,..., Gn de six éoliennes à une sous-station S « offshore » par l'intermédiaire de câbles C1,..., Cn sous-marin de grande section et de grande distance, par exemple 50 km.

Chaque éolienne H comprend un module de puissance comprenant une machine électrique synchrone multiphases et multicanaux et son convertisseur de puissance multicanaux associé, et un contrôleur d'éolienne. Une éolienne H fournit par exemple une puissance électrique nominale de 6MW.

La sous-station S comprend une plate-forme PT qui est ancrée sur le fond marin et est située au-dessus du niveau de la mer.

La sous-station S comprend en outre un groupe électrogène G comprenant au moins un moteur thermique diesel et délivrant généralement une puissance électrique de 1 MW, une barre d'inductance L et un contrôleur de champ d'éoliennes MC.

Le groupe électrogène G génère la puissance électrique nécessaire au fonctionnement des éoliennes H, notamment lors des phases de test.

La barre d'inductance L est reliée aux câbles C1,..., C2 afin de compenser la puissance réactive générée par le champ d'éoliennes et transférée par les câbles C1 et C2 et stabiliser le circuit électrique.

On connaît de l'état de la technique une procédure de test d'un champ d'éoliennes. Lors de la procédure de test, une barre d'inductance Lt et un banc de résistances R sont reliés aux câbles C1 et C2 pour compenser la puissance réactive et dissiper la puissance active, respectivement.

On considérera à présent la procédure de test d'une éolienne Ha.

Les différentes phases de la procédure de test sont contrôlées par un contrôleur d'éolienne incorporé dans l'éolienne Ha et le contrôleur de champ d'éoliennes MC.

Dans une première phase, l'éolienne Ha est entraînée en rotation par la puissance délivrée par le groupe électrogène G.

Puis les pâles de l'éolienne Ha sont orientées de sorte qu'elles soient entraînées par le vent et que l'éolienne Ha délivre une puissance électrique.

La puissance générée par l'éolienne Ha dissipée dans le banc de résistances R est comparée à des valeurs de référence.

Cependant, la procédure usuelle de test présente plusieurs inconvénients.

Le dispositif de test nécessite en premier lieu l'emploi d'une barre d'inductance et d'un banc de résistances qui seront retirés à la fin de la procédure de test, avant que la station de conditionnement soit reliée au réseau. Ces éléments ne sont utilisés que pendant la procédure de test et nécessitent de prévoir un espace de stockage sur la plate-forme qui ne sera utilisé que pendant la procédure de test, qui dure généralement 6 mois, alors que la durée d'utilisation d'un champ d'éoliennes est généralement de 25 ans.

De surcroît, la procédure de test se limite à une plage de puissance d'utilisation réduite, généralement jusqu'à 20% de la puissance nominale du module.

La procédure usuelle de test ne permet donc pas de tester le module de puissance à sa puissance nominale.

WO 2015/058769 A1 concerne un procédé de commande d'une centrale éolienne, la centrale éolienne comprenant un organe de commande de centrale servant à commander une pluralité d'aérogénérateurs.

Au vu de ce qui précède, il est proposé de pallier les inconvénients des procédures de modules de puissance selon l'état de la technique.

Il est donc proposé, selon un aspect, un dispositif de test d'un module d'un ensemble de modules de puissance raccordés entre eux.

Le dispositif comporte des moyens de compensation de puissance réactive aptes à compenser la puissance réactive transférée entre un module de puissance testé et les autres modules de puissance, et des moyens de contrôle de la puissance générée par le module de puissance testé comprenant des moyens de comparaison de ladite puissance générée avec au moins une valeur de seuil.

Les moyens de compensation de la puissance réactive sont constitués par l'un des modules de puissance configuré pour compenser la puissance réactive échangée avec le module de puissance testé.

Chaque module de puissance comprend une machine électrique synchrone multiphases et multicanaux comportant un stator comprenant plusieurs groupes de trois phases avec un niveau de couplage magnétique permettant de contrôler chaque canal de manière séparée.

Avantageusement, chaque canal de la machine électrique synchrone multiphases et multicanaux fonctionne en mode moteur ou générateur de puissance.

Le dispositif peut comporter en outre des moyens de production d'énergie raccordés auxdits modules de puissance et aptes à accélérer le module testé.

Avantageusement, les moyens de production d'énergie comprennent un groupe électrogène comprenant un moteur diesel.

Selon un autre mode de réalisation, les moyens de production d'énergie comprennent un module de puissance additionnel.

Selon un aspect, les modules de puissance tels que définis précédemment sont embarqués dans une nacelle d'éolienne.

Selon encore un autre aspect, il est proposé un procédé de test d'un ensemble de modules de puissance raccordés entre eux.

On compense la puissance réactive transférée entre un module de puissance testé et les autres modules de puissance, on contrôle la puissance générée par le module de puissance testé, et on compare ladite puissance générée avec au moins une valeur de seuil.

De préférence, le procédé comporte
une phase de démarrage durant laquelle on alimente le module de puissance testé jusqu'à ce qu'il atteigne la vitesse de connexion suivie ;
et une phase de contrôle de ladite puissance générée par le module de puissance testé comportant une machine électrique synchrone multiphases et multicanaux comportant un stator comprenant des phases raccordées entre elles par groupes de trois phases et dans lequel on entraîne le rotor de la machine électrique par l'intermédiaire d'au moins un groupe de trois phases à une vitesse de rotation prédéterminée, un ou plusieurs autres groupes de trois phases dudit module de puissance testé fonctionnant en mode générateur et l'on applique un couple électromagnétique sur le rotor de la machine électrique synchrone multiphases et multicanaux dudit module de puissance testé.

D'autres buts, caractéristiques et avantages de l'invention apparaîtront à la lecture de la description suivante, donnée uniquement à titre d'exemple non limitatif, et faite en référence aux dessins annexés sur lesquels :
- la figure 1, dont il a déjà été fait mention, montre un champ d'éoliennes situé en mer dans lequel une procédure de test selon l'état de la technique peut être mise en oeuvre ;
- la figure 2 montre un champ d'éoliennes offshore mettant en oeuvre une procédure de test selon l'invention ;
- la figure 3 montre un schéma électrique de puissance d'un module de puissance électrique comprenant une machine électrique synchrone multiphases et un convertisseur de puissance multicanaux ;
- la figure 4 illustre un canal du convertisseur de puissance multicanaux ; et
- la figure 5 décrit une procédure de test du champ d'éoliennes ;
- la figure 6 montre les échanges de puissance électrique du procédé de test selon un mode de réalisation de l'invention; et
- la figure 7 décrit une procédure de test d'un module de puissance d'une nacelle d'éolienne.

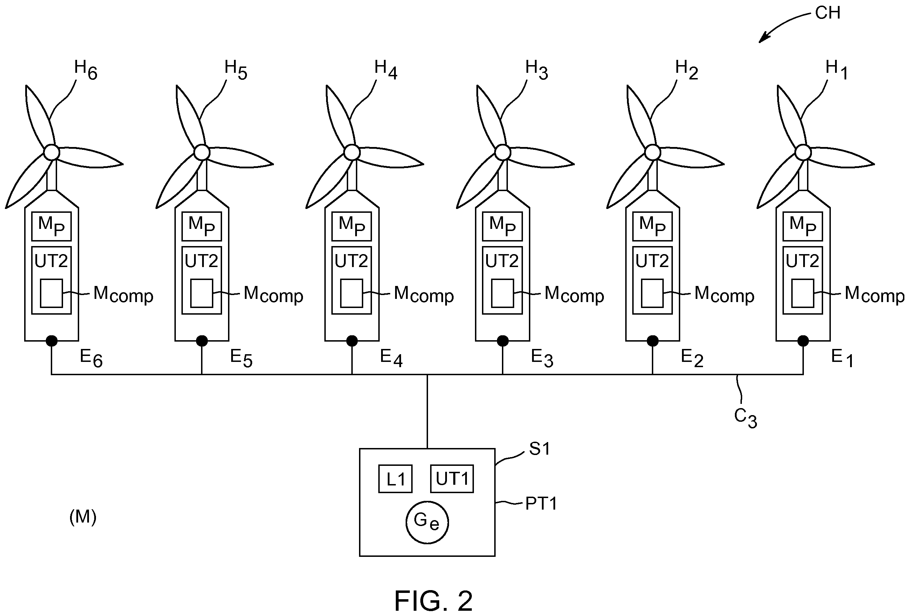

On se référera à la figure 2 qui montre un dispositif de test d'un ensemble de modules de puissance Mp raccordés entre eux, chaque module de puissance comprend une machine électrique synchrone multiphases et multicanaux et un convertisseur de puissance multicanaux associé. Les modules de puissance Mp sont ici des modules générateurs et consommateurs de puissance. Par exemple, dans une application nullement limitative, chaque module Mp de puissance est intégré dans la nacelle d'une éolienne.

Les éoliennes forment un champ CH d'éoliennes « offshore », en mer (M).

Afin d'améliorer la clarté de l'exposé, le champ d'éoliennes tel qu'illustré comprend un lot de six éoliennes H1, H2, H3, H4, H5 et H6 à pales variables comprenant chacune une borne de connexion E1, E2, E3, E4, E5 et E6 pour leur raccordement à un câble C3, un module de puissance Mp, et des moyens de contrôle de la puissance générée par le module de puissance comprenant une unité de traitement et de contrôle de puissance UT2. Le câble C3 relie les éoliennes H1, H2, H3, H4, H5 et H6 entre elles et à une sous-station S1 comprenant une plate-forme PT1 ancrée sur le fond marin et située au dessus du niveau de la mer (M).

Bien entendu, le champ CH d'éoliennes peut comprendre plusieurs lots, chaque lot comprenant plusieurs éoliennes, par exemple 6 éoliennes. Les éoliennes d'un même lot sont reliées entre elles et à la station de conditionnement par un même câble.

La sous-station S1 comprend une inductance L1, une unité de traitement et de supervision UT1 de champ d'éoliennes et un groupe électrogène Ge installés sur la plate-forme PT.

Le groupe électrogène Ge génère une puissance électrique qui alimente la station S1 et les éoliennes H1, H2, H3, H4, H5 et H6 par l'intermédiaire du câble C3. Il comprend par exemple au moins un moteur thermique diesel délivrant une puissance électrique de 1 MW.

L'inductance L1 permet de stabiliser le circuit électrique comprenant les éoliennes, le câble C3 et la sous-station S1.

Les éoliennes H1, H2, H3, H4, H5 et H6 sont de constitution identique.

L'unité de traitement et de supervision UT1 assure le pilotage du champ CH d'éoliennes en régulant les échanges de puissance dans le champ d'éoliennes, notamment entre les éoliennes et la sous-station S1, et l'unité de traitement et de contrôle de puissance UT2 pilote l'éolienne dans laquelle elle est implémentée. En d'autres termes, l'unité de traitement et de contrôle de puissance UT2 pilote le groupe de puissance Mp et l'orientation des pâles de l'éolienne. Les deux unités de traitement UT1 et UT2 interagissent entre-elles.

Les unités de traitement UT1 et UT2 sont par exemple réalisées à partir d'un microprocesseur. Il peut s'agir de tout dispositif apte à superviser un ensemble de modules de puissance. Il s'agit par exemple, dans l'exemple décrit, d'un dispositif apte à contrôler un module de puissance d'éoliennes et à orienter les pales d'une éolienne. Il peut s'agir notamment de microcontrôleurs.

Le dispositif comprend en outre des moyens de compensation de puissance réactive aptes à compenser la puissance réactive transférée entre un module de puissance testé et les autres modules de puissance et des moyens de comparaison Mcomp de la puissance générée par le module de puissance testé avec au moins une valeur de seuil.

Les moyens de comparaison Mcomp sont de préférence incorporés dans l'unité de traitement UT2 de l'éolienne testée. Bien entendu, il peut s'agir de tout dispositif apte à comparer la puissance générée par le module de puissance testé avec au moins une valeur de seuil et incorporé dans les moyens de contrôle. Il peut s'agir notamment d'un dispositif réalisé à partir d'un microprocesseur.

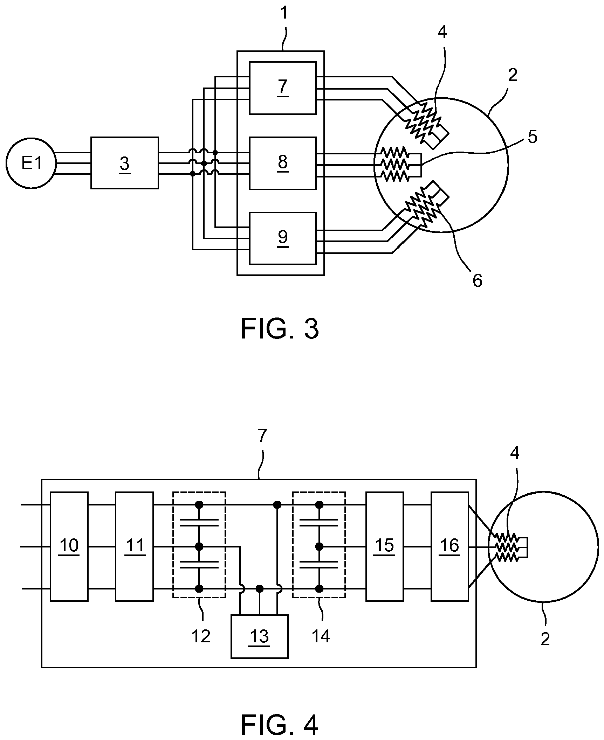

On se référera à la figure 3 qui illustre le schéma électrique de puissance d'une nacelle d'éolienne H1. Comme on le voit, une nacelle d'éolienne comprend un transformateur triphasé 3 relié au connecteur E1 et un module de puissance électrique comportant une machine électrique 2 multiphases et multicanaux et un convertisseur 1 de puissance triphasé multicanaux.

Les entrées de même phase du convertisseur de puissance 1 sont reliées entre elles et à la sortie correspondante du transformateur triphasé 3. L'ensemble du dispositif comprenant le convertisseur de puissance 1 et la machine électrique multiphases et multicanaux 2 est piloté par l'unité de traitement UT2.

La machine électrique synchrone multiphases et multicanaux 2 comprend un stator et un rotor. Le stator comprend plusieurs phases multiples de trois. Les phases sont raccordées entre elles par groupes de trois phases. Dans ce qui suit, à titre d'exemple non limitatif, les trois phases d'un groupe sont raccordées en configuration étoile. Bien entendu, on ne sort pas de l'invention lorsque les phases sont raccordées en configuration quelconque, notamment mais non exclusivement en configuration triangle. Les étoiles présentent un fort découplage magnétique entre elles. Par conséquent, les flux magnétiques générés par une configuration étoile ne viennent pas perturber une autre configuration étoile. Le niveau de découplage magnétique permet de contrôler chaque canal de manière séparée.

Sur la figure 3, la machine 2 comporte par exemple neuf phases regroupées en trois groupes 4, 5 et 6 de phases triples raccordées en étoile.

Le convertisseur de puissance 1 comporte plusieurs canaux de constitution identique. Chaque sortie d'un canal est raccordée à un groupe de phases triples en configuration étoile de la machine électrique 2. Par conséquent le nombre de canaux du convertisseur de puissance 1 est égal au nombre de groupes de phases triples en configuration étoile de la machine 2. Les entrées des canaux de même phase sont reliées entre elles et à la sortie correspondante du transformateur 3.

Sur la figure 3, la machine électrique comporte trois groupes 4, 5 et 6 de phases triples en configuration étoile. Par conséquent, le convertisseur de puissance 1 comporte trois canaux 7, 8, 9.

On se référera à la figure 4 qui montre la constitution d'un canal 7 du convertisseur de puissance multicanaux 1 fonctionnant en mode moteur ou générateur de puissance. Tous les canaux sont de constitution identique.

Le canal 7 comprend un dispositif de filtrage des harmoniques 10 dont les entrées sont destinées à être raccordées au transformateur 3 et aux autres entrées du canal du convertisseur de puissance 1. Les sorties du dispositif de filtrage 10 sont reliées aux entrées d'un pont redresseur commandé et réversible 11. Les sorties du pont 11 sont reliées à un banc de capacités 12. Le banc de capacités 12 comporte deux groupes de condensateurs reliés en série dont les extrémités sont reliées au pont 11, à un hacheur de freinage 13 et aux entrées d'un onduleur de tension réversible 15, et dont le point milieu entre les deux condensateurs est relié au hacheur de freinage. Un second banc de capacités 14 de constitution identique au banc de capacités 12 est relié aux entrées de l'onduleur de tension réversible 15. Le point milieu entre les deux groupes de condensateurs du banc de capacités 14 est relié à l'onduleur de tension réversible 15. Les sorties de l'onduleur de tension 15 sont reliées à un filtre dv/dt 16. Les sorties du filtre 16 sont reliées à un groupe de phases triples en configuration étoile de la machine électrique 2.

Le dispositif de filtrage 10, le pont redresseur commandé et réversible 11, le hacheur de freinage 13, l'onduleur de tension réversible 15 et le filtre dv/dt 16 ne seront pas abordés de manière détaillée car ces éléments sont connus de l'homme du métier.

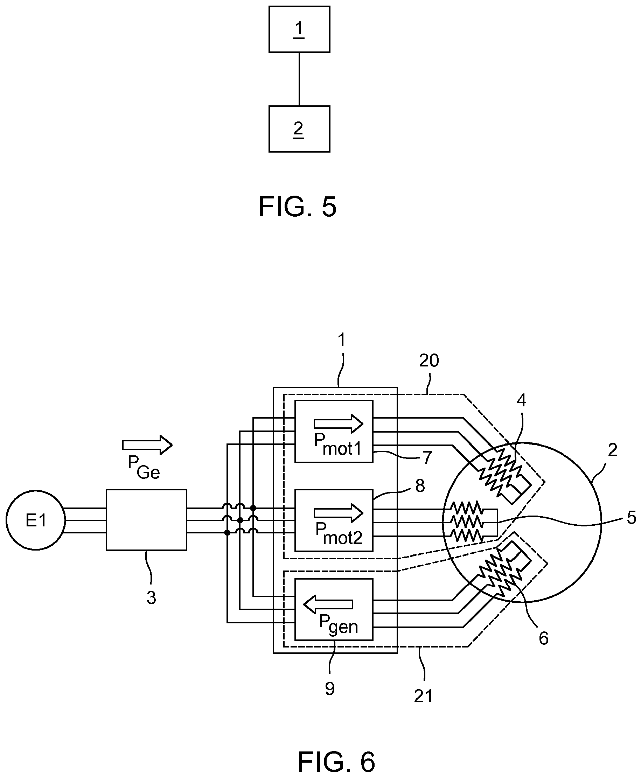

A présent, un premier mode de mise en oeuvre de la procédure de test du champ d'éoliennes représenté à la figure 2 est décrit à la figure 5.

Dans ce mode de mise en oeuvre de la procédure de test du champ d'éoliennes, on fait fonctionner l'une des éoliennes en mode de compensation de puissance réactive et l'on teste le fonctionnement d'une autre éolienne par contrôle de la puissance générée par l'éolienne.

En d'autres termes, on compense la puissance réactive transférée entre un module de puissance testé et les autres modules de puissance, on contrôle la puissance générée par le module de puissance testé, et on compare ladite puissance générée avec au moins une valeur de seuil.

Dans une étape 1, un premier module de puissance Mp incorporé dans l'une des éoliennes, en l'espèce l'éolienne référencée H1, et comprenant la machine électrique 2 multiphases et multicanaux et le convertisseur 1 de puissance multicanaux, fonctionne de sorte à compenser la puissance réactive générée par le champ d'éolienne CH et transférée par le câble C3. Ce mode de fonctionnement de l'éolienne est appelé mode de compensation de puissance réactive CPR.

Une consigne de puissance réactive à compenser est déterminée par l'unité de traitement UT1 et transmise à l'unité de traitement UT2 de l'éolienne H1 qui pilote le module de puissance de H1 de telle façon à compenser la puissance réactive.

Puis dans une étape 2, le module de puissance incorporé dans l'autre éolienne H2 est testé par contrôle de la puissance générée par l'éolienne. Bien entendu, la procédure de test du module de puissance est identique pour chaque module incorporé dans l'une des éoliennes H1, H2, H3, H4, H5 et H6.

En d'autres termes, les moyens de compensation de puissance réactive sont constitués par le module de puissance Mp incorporé dans l'éolienne référencée H1 configuré pour compenser la puissance réactive échangée avec le module de puissance H2 testé.

L'éolienne fonctionnant en mode de compensation de puissance réactive est n'importe laquelle des éoliennes H1, H2, H3, H4, H5 et H6 à l'exclusion de l'éolienne testée.

Dans le cas d'un champ d'éoliennes comportant plusieurs lots, au moins une éolienne par lot fonctionne en mode de compensation de puissance réactive CPR pendant toute la durée de la procédure de test.

Cette procédure est reproduite pour chaque éolienne du champ d'éoliennes. La procédure peut être réalisée pour une éolienne à la fois, pour plusieurs éoliennes à la fois ou pour l'ensemble des éoliennes du champ en une opération de test. Les puissances mises en jeu seront adaptées selon le nombre d'éoliennes testées simultanément.

En mode CPR, les bobines des groupes 4, 5 et 6 de phases de la machine électrique 2 sont utilisées comme des inductances. L'onduleur de tension réversible 15 ajuste le déphasage entre l'intensité traversant chaque phase et la tension aux bornes de chaque phase de manière à compenser la puissance réactive dans le réseau. L'onduleur de tension est commandé par l'unité de traitement UT1 de champ d'éoliennes de telle manière à délivrer une consigne de compensation de puissance réactive.

Avantageusement, aucune barre d'inductance supplémentaire n'est nécessaire pour réaliser la procédure de test du champ d'éoliennes.

La figure 6 montre les flux d'échange de puissance électrique d'un ensemble étoile et onduleur de tension associé incorporé dans l'éolienne H2. Comme on le voit sur cette figure, une puissance P_{Ge} est transmise par le transformateur 3 et alimente le convertisseur de puissance 1. Les groupes de phases 4 et 5 de la machine 2 sont alimentés par des puissances motrices Pmot1 et Pmot2 délivrées par le convertisseur de puissance 1, et le groupe de phases 6 génère une puissance Pgen qui alimente le convertisseur 1.

La procédure de test est répétée pour chaque groupe de phases triples ou pour plusieurs groupes de phases triples en configuration étoile de la machine électrique 2 et le ou les canaux associés du convertisseur de puissance 1 à tester.

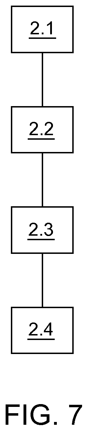

La figure 7 détaille la procédure de test d'un module de puissance d'une nacelle d'éolienne, précédemment décrite à l'étape 2 de la figure 5, et, en particulier, de l'ensemble 21 visible sur la figure 6 qui comprend le groupe de phases triples en configuration étoile 6 et le canal 9 du convertisseur de puissance 1.

Le rotor de la machine électrique 2 est mis en mouvement par l'ensemble 20 de phases triples 4 et 5 en configuration étoile alimentées par les canaux 7 et 8 du convertisseur de puissance 1.

Lors de l'étape 2.1 de démarrage de la procédure de test, l'ensemble 20 est alimenté par des moyens de production d'énergie aptes à accélérer le module de puissance testé jusqu'à ce qu'il atteigne la vitesse de connexion.

La vitesse de connexion correspond à la vitesse de rotation à partir de laquelle la machine électrique et le convertisseur de puissance produiraient une puissance électrique suffisante pour alimenter un réseau électrique s'ils fonctionnaient en mode générateur. Dans le cas d'une éolienne, la vitesse de connexion est par exemple de 3.7 tr/min.

Les moyens de production d'énergie comprennent le groupe électrogène Ge de la sous-station S1 par l'intermédiaire du transformateur 3 relié à la borne de connexion E1.

La puissance électrique P_{Ge} fournie par le groupe électrogène Ge est transmise à l'éolienne H2 par l'intermédiaire du câble C3. Le transfert de puissance électrique est piloté par l'unité de traitement UT1 de champ d'éoliennes en mode régulation de puissance et par l'unité de traitement UT2 d'éolienne de l'éolienne H2.

Les groupes de phases triples 4 et 5 en configuration étoile sont dites motrices.

Le nombre de groupes de phases triples motrices, en configuration étoile, est choisi de telle sorte que la puissance nominale motrice totale délivrée par les étoiles soit au moins égale à la puissance nominale de l'ensemble testé.

La machine électrique 2 est contrôlée en vitesse par l'unité de traitement UT2 de l'éolienne testée H2.

A l'étape 2.2, lorsque le rotor de la machine électrique 2 atteint la vitesse de connexion, et après synchronisation de l'ensemble 21, l'ensemble 21 testé, est piloté de telle sorte qu'il fonctionne en mode générateur de puissance.

L'ensemble 21 pilote le couple de la machine électrique 2.

La puissance électrique Pgen générée par l'ensemble 21 est transférée à l'ensemble moteur 20.

L'unité de traitement UT2 de l'éolienne pilote l'ensemble 21 et oriente les pales de l'éolienne H2 de telle sorte que la somme des puissances motrices Pmot1 et Pmot2 consommées par l'ensemble 20 est égale à la puissance Pgen.

A l'étape 2.3, lorsque la somme des puissances motrices Pmot1 et Pmot2 consommées par l'ensemble 20 est égale à la puissance Pgen, la phase contrôle de la puissance générée par le module de puissance testé débute.

Le groupe électrogène Ge ne fournit plus à présent de puissance électrique à l'éolienne H2.

L'éolienne H2 est à présent autonome et est pilotée par l'unité de traitement UT2.

Le couple électromagnétique résistif généré par l'ensemble 21 comprenant un groupe de phases triples en configuration étoile 6 et le canal 9 du convertisseur de puissance 1 associé appliqué sur le rotor de la machine électrique 2 est progressivement augmenté. Par conséquent, la vitesse de rotation du rotor diminue. L'unité de traitement UT2 augmente la puissance motrice délivrée par l'ensemble 20 jusqu'à ce que la consigne en vitesse de rotation soit atteinte. Le couple résistif peut ainsi être augmenté jusqu'à ce que la puissance générée par le couple résistif soit égale à la puissance motrice générée par l'ensemble 20.

Puis à l'étape 2.4, la puissance générée par l'ensemble 21 est comparée aux valeurs attendues afin de valider le fonctionnement de l'ensemble 21 par les moyens de comparaison Mcomp.

Cette procédure de test présente l'avantage de tester le module de puissance sur toute sa gamme de puissance en utilisant les chaînes d'acquisition, de contrôle et de puissance du module par exemple dans le cas d'une éolienne.

Avantageusement, le dispositif de test présente une architecture permettant d'assurer les échanges de puissance active au sein du module de puissance. En d'autres termes, lors de la deuxième phase de test, le module de puissance fonctionne de façon autonome en n'échangeant plus de puissance active avec le champ d'éoliennes.

Par conséquent, aucun banc de résistances n'est requis pour effectuer la procédure de test et la consommation énergétique du groupe électrogène est réduite.

Avantageusement, la plate-forme de la station de conditionnement est de taille réduite par rapport à celle connue de l'état de la technique.

Selon un autre mode de mise en oeuvre de la procédure de test, les moyens de production d'énergie comprennent un module de puissance additionnel fonctionnant en mode génératrice incorporé par exemple dans une éolienne. Ces moyens de production se substituent au groupe électrogène Ge.

L'éolienne fonctionne en mode génératrice et alimente en puissance électrique l'éolienne testée. La procédure de test est identique à celle décrite dans le mode de mise en oeuvre précédent. Dans ce mode de mise en oeuvre, le contrôleur de champ d'éolienne fonctionne en mode régulation de tension et le contrôleur de l'éolienne génératrice de puissance électrique fonctionne en régulation de puissance en exportant de la puissance sur le réseau.

En d'autres termes, la puissance nécessaire lors de la phase de démarrage de la procédure de test est générée par le vent. Par conséquent, la consommation de fioul du groupe électrogène est nulle.

## Revendications

1. Dispositif de test d'un module de puissance (Mp) d'un ensemble de modules de puissance (Mp) raccordés entre eux, le dispositif de test comportant des moyens de compensation de la puissance réactive (1, 2) configurés pour compenser la puissance réactive transférée entre le module de puissance testé et les autres modules de puissance, et des moyens de contrôle de la puissance générée (UT2) par le module de puissance testé, lesdits moyens de contrôle de la puissance générée comprenant des moyens de comparaison (Mcomp) de ladite puissance générée avec au moins une valeur de seuil, les moyens de compensation de la puissance réactive étant constitués par l'un des modules de puissance configuré pour compenser la puissance réactive échangée avec le module de puissance testé, **caractérisé en ce que** chaque module de puissance comprend une machine électrique synchrone multiphases et multicanaux (2) comportant un stator comprenant plusieurs groupes de trois phases (4, 5, 6) avec un niveau de couplage magnétique permettant de contrôler chaque canal de manière séparée.

2. Dispositif selon la revendication 1, dans lequel chaque canal de la machine électrique synchrone multiphases et multicanaux (2) fonctionne en mode moteur ou générateur de puissance.

3. Dispositif selon l'une des revendications 1 ou 2, comportant en outre des moyens de production d'énergie raccordés auxdits modules de puissance et configurés pour accélérer le module testé.

4. Dispositif selon la revendication 3, dans lequel les moyens de production d'énergie comprennent un groupe électrogène (Ge) comprenant un moteur diesel.

5. Dispositif selon la revendication 3, dans lequel les moyens de production d'énergie comprennent un module de puissance (Mp) additionnel.

6. Dispositif selon l'une quelconque des revendications 1 à 5, dans lequel les modules de puissance sont des modules de puissance (Mp) embarquées dans une nacelle d'éolienne.

7. Procédé de test d'un module de puissance (Mp) d'un ensemble de modules de puissance raccordés entre eux, dans lequel on compense la puissance réactive transférée entre le module de puissance testé et les autres modules de puissance, on contrôle la puissance générée par le module de puissance testé, et on compare ladite puissance générée avec au moins une valeur de seuil, la compensation de la puissance réactive transférée entre ledit module de puissance testé et les autres modules de puissance étant réalisée par l'un des modules de puissance configuré pour compenser la puissance réactive échangée avec le module de puissance testé, **caractérisé en ce que** chaque module de puissance comprend une machine électrique synchrone multiphases et multicanaux (2) comportant un stator comprenant plusieurs groupes de trois phases (4, 5, 6) avec un niveau de couplage magnétique permettant de contrôler chaque canal de manière séparée.

8. Procédé selon la revendication 7, comprenant
une phase de démarrage durant laquelle on alimente le module de puissance testé jusqu'à ce qu'il atteigne la vitesse de connexion suivie ; et
une phase de contrôle de ladite puissance générée par le module de puissance testé, et dans lequel on entraîne le rotor de la machine électrique par l'intermédiaire d'au moins un groupe de trois phases à une vitesse de rotation prédéterminée, un ou plusieurs autres groupes de trois phases dudit module de puissance testé fonctionnant en mode générateur et l'on applique un couple électromagnétique sur le rotor de la machine électrique synchrone multiphases et multicanaux dudit module de puissance testé.

## Patentansprüche

1. Vorrichtung zum Testen eines Leistungsmoduls (Mp) einer Anordnung von miteinander verbundenen Leistungsmodulen (Mp), wobei die Testvorrichtung Blindleistungskompensationsmittel (1, 2), die dazu konfiguriert sind, die Blindleistung, die zwischen dem getesteten Leistungsmodul und den anderen Leistungsmodulen übertragen wird, zu kompensieren, und Steuerungsmittel (UT2) für die vom getesteten Leistungsmodul erzeugte Leistung umfasst, wobei die Steuerungsmittel für die erzeugte Leistung Vergleichsmittel (Mcomp) für die erzeugte Leistung mit mindestens einem Schwellenwert enthalten, wobei die Vergleichsmittel für die Blindleistung aus einem der Leistungsmodule bestehen, das dazu konfiguriert ist, die mit dem getesteten Leistungsmodul ausgetauschte Blindleistung zu kompensieren, **dadurch gekennzeichnet, dass** jedes Leistungsmodul eine mehrphasige und mehrkanalige elektrische Synchronmaschine (2) enthält, die einen Stator umfasst, der mehrere Gruppen von drei Phasen (4, 5, 6) mit einem Grad der magnetischen Kopplung enthält, der es ermöglicht, jeden Kanal separat zu steuern.

2. Vorrichtung nach Anspruch 1, wobei jeder Kanal der mehrphasigen und mehrkanaligen elektrischen Synchronmaschine (2) im Motor- oder Leistungsgeneratormodus arbeitet.

3. Vorrichtung nach einem der Ansprüche 1 oder 2, die ferner Energieerzeugungsmittel umfasst, die mit den Leistungsmodulen verbunden und dazu konfiguriert sind, das getestete Modul zu beschleunigen.

4. Vorrichtung nach Anspruch 3, wobei die Energieerzeugungsmittel eine Stromerzeugungsgruppe (Ge) enthalten, die einen Dieselmotor enthält.

5. Vorrichtung nach Anspruch 3, wobei die Energieerzeugungsmittel ein zusätzliches Leistungsmodul (Mp) enthalten.

6. Vorrichtung nach einem der Ansprüche 1 bis 5, wobei die Leistungsmodule Leistungsmodule (Mp) sind, die in eine Gondel einer Windkraftanlage eingebettet sind.

7. Verfahren zum Testen eines Leistungsmoduls (Mp) einer Anordnung von miteinander verbundenen Leistungsmodulen, wobei die Blindleistung, die zwischen dem getesteten Leistungsmodul und den anderen Leistungsmodulen übertragen wird, kompensiert wird, die vom getesteten Leistungsmodul erzeugte Leistung gesteuert wird und die erzeugte Leistung mit mindestens einem Schwellenwert verglichen wird, wobei die Kompensation der Blindleistung, die zwischen dem getesteten Leistungsmodul und den anderen Leistungsmodulen übertragen wird, durch das eine der Leistungsmodule durchgeführt wird, das dazu konfiguriert ist, die mit dem getesteten Leistungsmodul ausgetauschte Blindleistung zu kompensieren,
**dadurch gekennzeichnet, dass** jedes Leistungsmodul eine mehrphasige und mehrkanalige elektrische Synchronmaschine (2) enthält, die einen Stator umfasst, der mehrere Gruppen von drei Phasen (4, 5, 6) mit einem Grad der magnetischen Kopplung enthält, der es ermöglicht, jeden Kanal separat zu steuern.

8. Verfahren nach Anspruch 7, das Folgendes umfasst:
eine Anlaufphase, während der das getestete Leistungsmodul mit Strom versorgt wird, bis es die verfolgte Verbindungsgeschwindigkeit erreicht; und
eine Phase zum Steuern der von dem getesteten Leistungsmodul erzeugten Leistung, wobei der Rotor der elektrischen Maschine mit Hilfe mindestens einer Gruppe von drei Phasen mit einer vorgegebenen Drehzahl angetrieben wird, eine oder mehrere andere Gruppen von drei Phasen des getesteten Leistungsmoduls im Generatormodus arbeiten und ein elektromagnetisches Drehmoment auf den Rotor der elektrischen mehrphasigen und mehrkanaligen elektrischen Synchronmaschine des getesteten Leistungsmoduls angewandt wird.

## Claims

1. A device for testing a power module (Mp) of a set of power modules (Mp) connected together, the test device including reactive power compensation means (1, 2) configured to compensate the reactive power transferred between the tested power module and the other power modules, and means for controlling the power generated (UT2) by the tested power module, said means for controlling the generated power comprising means for comparing (Mcomp) said generated power with at least one threshold value, the means for compensating the reactive power being constituted by one of the power modules configured to compensate the reactive power exchanged with the tested power module, **characterised in that** each power module comprises a multi-phase and multi-channel synchronous electric machine (2) including a stator comprising several groups of three phases (4, 5, 6) with a level of magnetic coupling allowing each channel to be controlled separately.

2. The device according to claim 1, wherein each channel of the multi-phase and multi-channel synchronous electric machine (2) operates in motor or power generator mode.

3. The device according to one of claims 1 or 2, further including energy production means connected to said power modules and configured to accelerate the tested module.

4. The device according to claim 3, wherein the energy production means comprise a generator set (Ge) comprising a diesel engine.

5. The device according to claim 3, wherein the energy production means comprise an additional power module (Mp) .

6. The device according to any one of claims 1 to 5, wherein the power modules are power modules (Mp) embedded in a wind turbine nacelle.

7. A method for testing a power module (Mp) of a set of power modules connected together, wherein the reactive power transferred between the tested power module and the other power modules is compensated, the power generated by the tested power module, and said generated power is compared with at least one threshold value, the compensation of the reactive power transferred between said tested power module and the other power modules being carried out by one of the power modules configured to compensate for the reactive power exchanged with the tested power module,
**characterised in that** each power module comprises a multi-phase and multi-channel synchronous electric machine (2) including a stator comprising several groups of three phases (4, 5, 6) with a level of magnetic coupling allowing to control each channel separately.

8. The method according to claim 7, comprising a start-up phase during which the tested power module is powered until it reaches the followed connection speed; and
a phase of controlling said power generated by the tested power module, and wherein the rotor of the electric machine is driven via at least one group of three phases at a predetermined rotational speed, one or more other groups of three phases of said tested power module operating in generator mode and an electromagnetic torque is applied to the rotor of the multi-phase and multi-channel synchronous electric machine of said tested power module.
